## Europäisches Patentamt
## European Patent Office
## Office européen des brevets

(19)

(11) Veröffentlichungsnummer: **0 212 105 B1**

(12) **EUROPÄISCHE PATENTSCHRIFT**

(45) Veröffentlichungstag der Patentschrift: **11.09.91**

(21) Anmeldenummer: **86107727.9**

(22) Anmeldetag: **06.06.86**

(51) Int. Cl.⁵: **H03G 3/32**, H03H 7/25, H03G 1/00

(54) **Einrichtung zur geschwindigkeitsabhängigen Lautstärkeanhebung in einem Kraftfahrzeug.**

(30) Priorität: **23.08.85 DE 3530144**

(43) Veröffentlichungstag der Anmeldung:
**04.03.87 Patentblatt 87/10**

(45) Bekanntmachung des Hinweises auf die
Patenterteilung:
**11.09.91 Patentblatt 91/37**

(84) Benannte Vertragsstaaten:
**CH DE FR IT LI**

(56) Entgegenhaltungen:
**DE-A- 2 437 697          DE-A- 2 501 530
DE-A- 2 833 208          FR-A- 1 593 642
US-A- 3 188 554          US-A- 4 558 460**

(73) Patentinhaber: **GRUNDIG E.M.V. Elektro-
Mechanische Versuchsanstalt Max Grundig
holländ. Stiftung & Co. KG.
Kurgartenstrasse 37
W-8510 Fürth/Bay.(DE)**

(72) Erfinder: **Fischelmayer, Heinrich
Siebenbürgener Strasse 13
W-8502 Zirndorf(DE)**

## Beschreibung

Die Erfindung betrifft eine Einrichtung zur geschwindigkeitsabhängigen Lautstärkeanhebung für ein in ein Kraftfahrzeug einsetzbares Audiogerät, mit einer im NF-Signalweg des Audiogerätes anzuordnenden Dämpfungsschaltung, deren Signaldämpfung von einem von der Fahrgeschwindigkeit abhängigen Regelsignal gesteuert wird.

Eine solche Einrichtung ist aus der DE-OS 28 33 208 bekannt. Das geschwindigkeitsabhängige Regelsignal wird dort vom Ausgangssignal eines Tachogenerators oder Induktivgebers abgeleitet und einer zwischen dem Niederfrequenzausgang des Wiedergabegerätes und den zugehörigen Lautsprechern liegenden Dämpfungs-Steuerschaltung zugeführt.

Die bekannte Einrichtung hat insbesondere den Nachteil, daß die in Abhängigkeit von der Fahrgeschwindigkeit automatisch wirkende Lautstärkeanhebung im Gegensatz zur manuellen, üblicherweise gehörrichtigen Lautstärkeeinstellung eine für das menschliche Gehör störend wirkende Veränderung des Klangeindrucks zur Folge hat.

Der Erfindung liegt die Aufgabe zugrunde, eine Einrichtung der im Oberbegriff des Anspruchs 1 angegebenen Art mit einfachen Mitteln so auszubilden, daß eine geschwindigkeitsbedingte Lautstärkeerhöhung bzw. -erniedrigung keine Veränderung des jeweils vorher empfundenen Klangeindrucks bewirkt.

Diese Aufgabe wird gemäß der Erfindung durch die im kennzeichnenden Teil des Patentanspruchs 1 angegebenen Merkmale gelöst. Vorteilhafte Weiterbildungen der Erfindung sind in den Unteransprüchen gekennzeichnet.

Die Einrichtung zur geschwindigkeitsabhängigen Lautstärkeanhebung verfügt über eine steuerbare Impedanz, die in vorteilhafter Weise mit einem an sich bekannten Stellglied zur gehörrichtigen Lautstärkeeinstellung gekoppelt ist. Der Lautstärkesteller besitzt einen festen Abgriff, an den zur Anhebung der tiefen Frequenzen bei kleinen Lautstärken ein RC-Serienglied angeschlossen ist. Der zweite Anschluß des RC-Seriengliedes ist jedoch nicht wie üblich direkt, sondern über die steuerbare Impedanz mit dem Fußpunkt des Lautstärkestellers verbunden. Die steuerbare Impedanz selbst setzt sich in vorteilhafter Weise aus einem steuerbaren Widerstand sowie einem dazu parallel liegenden zweiten RC-Serienglied zusammen.

Ein von der Fahrgeschwindigkeit abhängiges Regelsignal bewirkt bei zunehmender Geschwindigkeit eine Vergrößerung des steuerbaren Widerstandes und damit eine frequenzabhängige Anhebung der mittels des Lautstärkestellers einstellbaren Grundlautstärke. Wie stark der Pegel des NF-Signals gegenüber dem eingestellten Grundwert angehoben wird, hängt gemäß der Erfindung auch von der Einstellung des Lautstärkestellers selbst ab. Die Pegelanhebung ist bei weit zurückgedrehtem Lautstärkesteller (kleine Grundlautstärke) sehr viel größer als bei weit aufgedrehtem Lautstärkesteller (große Grundlautstärke). Bei voll aufgedrehtem Lautstärkesteller findet keine Anhebung mehr statt, wodurch automatisch eine Übersteuerung des nachfolgenden Leistungsverstärkers vermieden wird. Durch das dem steuerbaren Widerstand parallelgeschaltete RC-Serienglied wird in einfacher Weise erreicht, daß der von der gehörrichtigen Lautstärkeeinstellung her gewohnte gleichbleibende Klangeindruck auch bei der geschwindigkeitsabhängigen Lautstärkeanhebung erhalten bleibt.

Besonders vorteilhaft ist es, als steuerbaren Widerstand eine Zenerdiode zu verwenden, die eine Durchbruchspannung von etwa 3 Volt aufweist. Derartige Zenerdioden haben eine schwächer gekrümmte Strom-Spannungs-Kennlinie als Zenerdioden mit höherer Durchbruchspannung und sind daher als steuerbare Widerstände besser geeignet. Die schwächer gekrümmte Strom-Spannungs-Kennlinie bewirkt insbesondere eine wesentliche Verkleinerung des Klirrfaktors. Grundsätzlich wären auch herkömmliche Gleichrichterdioden verwendbar. Diese zeigen gegenüber Zenerdioden jedoch ein wesentlich schlechteres Temperaturverhalten.

Die Erfindung ist im folgenden anhand von Zeichnungen näher erläutert. Es zeigen:

Fig. 1 eine in den NF-Signalweg eines Audiogerätes einfügbare Dämpfungsschaltung für eine Einrichtung gemäß der Erfindung,

Fig. 2 eine Anordnung zur Erzeugung eines von der Fahrgeschwindigkeit abhängigen Regelsignals,

Fig. 3a ein Kennlinienfeld, das bei konstant gehaltener Regelsteilheit die Lautstärkeanhebung der Einrichtung gemäß der Erfindung in Abhängigkeit von der Fahrgeschwindigkeit und der eingestellten Grundlautstärke als Parameter wiedergibt,

Fig. 3b ein Kennlinienfeld, das bei konstant gehaltener Grundlautstärke die Lautstärkeanhebung der Einrichtung gemäß der Erfindung in Abhängigkeit von der Fahrgeschwindigkeit und der Regelsteilheit als Parameter wiedergibt.

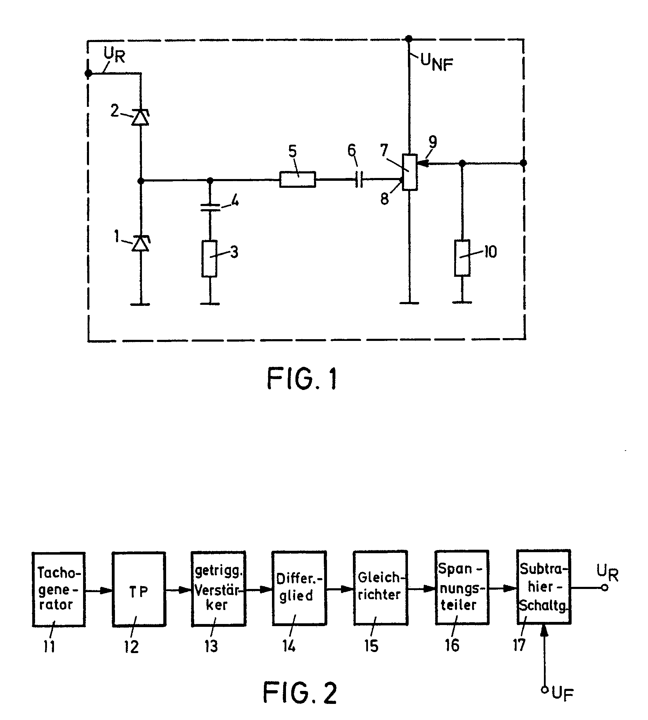

Bei dem in Figur 1 dargestellten Ausführungsbeispiel einer Dämpfungsschaltung für eine Einrichtung gemäß der Erfindung ist als steuerbarer Widerstand eine in Rückwärtsrichtung (Sperrichtung) betriebene Zenerdiode 1 vorgesehen, zu der eine zweite, gleichfalls in Rückwärtsrichtung (Sperrichtung) betriebene Zenerdiode 2 in Reihe geschaltet ist. Parallel zur Zenerdiode 1 liegt ein RC-Serienglied 3, 4. Der Verbindungspunkt der beiden Dioden 1, 2 mit dem RC-Serienglied 3, 4 ist über ein zweites RC-Serienglied 5, 6 an den festen Abgriff 8 eines mechanisch betätigten Lautstärkestellers 7 angeschlossen. Der Fußpunkt des Lautstärkestellers 7 liegt auf Masse und ist dort mit der Anode der Zenerdiode 1, dem Widerstand 3 des RC-Serangliedes 3, 4 sowie einem weiteren Widerstand 10 verbunden, der mit seinem anderen Anschluß zum variablen Abgriff 9 des Lautstärkestellers 7 führt.

Die an den Zenerdioden 1 und 2 liegende Regelspannung $U_R$ muß bei Stillstand des Fahrzeugs so groß sein, daß sich für die Dioden entsprechend ihrer Kennlinie ein sehr kleiner, gegen Null gehender differentieller Widerstand ergibt. In diesem Fall überbrückt die Zenerdiode 1 das RC-Serienglied 3, 4 und schaltet den Widerstand 5 des RC-Serangliedes 5, 6 direkt an Masse bzw. an den auf Masse liegenden Fußpunkt des Lautstärkestellers 7. Der Lautstärkesteller 7 bestimmt entsprechend der Stellung des variablen Abgriffs 9 die Grundlautstärke des Audiogerätes. Hierbei bewirkt das RC-Serienglied 5, 6 eine gehörrichtige Einstellung der Grundlautstärke derart, daß sich in bekannter Weise bei der Verringerung der Lautstärke eine zunehmende Anhebung der tiefen Frequenzen gegenüber den mittleren und hohen Frequenzen des zu übertragenden NF-Signals ergibt. Das menschliche Gehör empfindet somit einen von der (Grund-)Lautstärke unabhängigen und gleichbleibenden Klangeindruck.

Sobald das Fahrzeug vom Stillstand in den Fahrbetrieb übergeht, muß die Regelspannung $U_R$ proportional zum Anstieg der Fahrgeschwindigkeit auf kleinere Werte absinken. Mit dem Absinken der Regelspannung $U_R$ steigt der differentielle Widerstand der Zenerdioden 1 und 2 entsprechend ihren Strom-Spannungskennlinien an. Damit wird das RC-Serienglied 5, 6 über einen zunehmend größer werdenden Widerstand stärker von Masse getrennt, was zur Folge hat, daß die mittel- und höherfrequenten Signalkomponenten immer weniger gedämpft werden. Der zunehmende differentielle Widerstand der Zenerdiode 1 hat außerdem zur Folge, daß das zur Zenerdiode 1 parallelliegende RC-Serienglied 3, 4 wirksam wird. Dieses RC-Serienglied hat die Aufgabe einer geschwindigkeitsabhängigen Frequenzgangkorrektur, und zwar derart, daß der von der gehörrichtigen Lautstärkeeinstellung her gewohnte gleichbleibende Klangeindruck auch bei der geschwindigkeitsabhängigen Lautstärkeanhebung erzielt wird.

Durch die nichtlineare Kennlinie der Zenerdiode 1, die vorzugsweise eine Durchbruchspannung von etwa 3 Volt aufweist, ergibt sich für die Lautstärkeanhebung eine geschwindigkeitsabhängige Regelkennlinie, die bis zu einer Mindestgeschwindigkeit nicht oder nur sehr wenig ansteigt, ab dieser Mindestgeschwindigkeit in einen linear ansteigenden Verlauf übergeht und bei Erreichen eines oberen Geschwindigkeitswertes einem Grenzwert zustrebt.

Der Einfluß des differentiellen Diodenwiderstandes auf die Lautstärkeanhebung nimmt mit dem Übergang zu höheren Grundlautstärken immer mehr ab. Je höher also die Grundlautstärke mittels des Lautstärkestellers 7 gewählt wird, umso geringer ist die Lautstärkeanhebung bei einer bestimmten Zunahme der Fahrgeschwindigkeit. Diese Eigenschaft wird noch verstärkt, wenn entsprechend dem dargestellten Ausführungsbeispiel der variable Abgriff 9 des Lautstärkestellers 7 über einen ohmschen Widerstand 10, der kleiner ist als der Nennwert des Lautstärkestellers, an Masse gelegt wird.

Figur 2 zeigt ein Ausführungsbeispiel einer Anordnung zur Erzeugung eines geeigneten von der Fahrzeuggeschwindigkeit abhängigen Regelsignals $U_R$. Es handelt sich hierbei um einen Frequenz-Spannungs-Wandler, der aus einer frequenzvariablen Wechselspannung eine Gleichspannung erzeugt, deren Größe sich direkt proportional mit der Frequenz der Wechselspannung ändert.

Das Wechselspannungssignal mit einer von der Fahrgeschwindigkeit abhängigen Frequenz wird einem am Fahrzeugtachometer angeordneten Tachogenerator 11 entnommen. Es wird über ein Tiefpaßfilter 12, das zur Unterdrückung von HF-Störungen vorgesehen ist, an einen getriggerten Verstärker 13 geführt, der das Wechselspannungssignal in eine symmetrische Rechteckspannung umformt. Diese Rechteckspannung wird an ein Differenzierglied 14, z. B. einen Hochpaß, gelegt. Das Ausgangssignal des Differenziergliedes wird mittels einer entsprechend dimensionierten Gleichrichterschaltung 15 in eine Gleichspannung umgeformt, deren Größe direkt proportional mit der Frequenz der vom Tachogenerator abgegebenen Wechselspannung und damit direkt proportional mit der Fahrgeschwindigkeit zunimmt. Da als Regelsignal für die Dämpfungsschaltung gemäß Fig. 1 jedoch eine Gleichspannung benötigt wird, deren Größe mit zunehmender Fahrgeschwindigkeit gegebenenfalls bis auf den Wert Null absinkt, verfügt der Frequenz-Spannungswandler nach Fig. 2 noch über eine Subtrahier-Schaltung 17, die das gleichgerichtete Signal von einer vorgegebenen Festspannung $U_F$ subtrahiert.

Bei einem bevorzugten Ausführungsbeispiel ist zwischen dem Gleichrichter 15 und der Subtrahier-Schaltung 17 zusätzlich noch ein variabler Spannungsteiler 16 vorgesehen. Hierdurch wird die Möglichkeit geschaffen, festzulegen, wie schnell die Regelspannung $U_R$ in Abhängigkeit von der Geschwindigkeit des Fahrzeugs absinken und gegebenenfalls den das Ende der Regelung bestimmenden Wert Null erreichen soll. Das Teilungsverhältnis des Spannungsteilers 16 bestimmt somit die Regelsteilheit der Einrichtung gemäß der Erfindung.

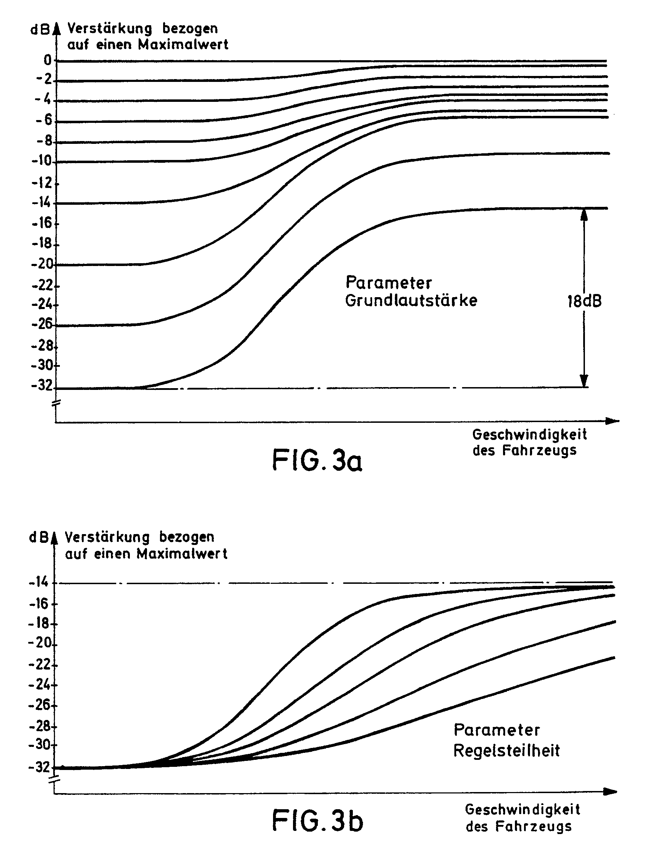

In Figur 3a ist ein Kennlinienfeld dargestellt, das bei konstant gehaltener Regelsteilheit die Lautstärkeanhebung der Einrichtung gemäß der Erfindung in Abhängigkeit von der Fahrgeschwindigkeit und der eingestellten Grundlautstärke als Parameter wiedergibt. Es ist zu erkennen, daß bei zunehmender Grundlautstärke die durch die Regelung bewirkte Lautstärkeanhebung immer kleiner wird und bei "voll aufgedrehtem" Lautstärkesteller gegen Null geht. Bei dem dargestellten Ausführungsbeispiel beträgt die maximale Lautstärkeanhebung - Lautstärkesteller ist auf eine sehr kleine Grundlautstärke eingestellt - etwa 18 dB.

In Figur 3b ist ein Kennlinienfeld dargestellt, das bei konstant gehaltener Grundlautstärke die Lautstärkeanhebung der Einrichtung gemäß der Erfindung in Abhängigkeit von der Fahrgeschwindigkeit und der Regelsteilheit als Parameter wiedergibt. Es ist ersichtlich, daß die gleiche Lautstärkeanhebung je nach Regelsteilheit bei verschiedenen Fahrgeschwindigkeiten erreicht werden kann. Die Einrichtung gemäß der Erfindung eignet sich daher sowohl für Fahrzeuge, die schon bei geringen Fahrgeschwindigkeiten einen hohen Geräuschpegel entwickeln, als auch für Fahrzeuge, die erst bei sehr hohen Geschwindigkeiten störende Fahrgeräusche aufweisen.

**Patentansprüche**

1. Einrichtung zur geschwindigkeitsabhängigen Lautstärkeanhebung für ein in ein Kraftfahrzeug einsetzbares Audiogerät, mit einer im NF-Signalweg des Audiogerätes anzuordnenden Dämpfungsschaltung mit einer steuerbaren Impedanz, deren Signaldämpfung von einem von der Fahrgeschwindigkeit abhängigen Regelsignal gesteuert wird, **dadurch gekennzeichnet,** daß die steuerbare Impedanz aus einem steuerbaren Widerstand (1) sowie einem dazu parallelgeschalteten ersten RC-Serienglied (3, 4) besteht, und daß die Dämpfungsschaltung ferner einen mechanisch betätigten Lautstärkesteller (7) sowie ein zweites RC-Serienglied (5, 6) aufweist, dessen erster Anschluß mit einem festen Abgriff (8) des Lautstärkestellers (7) und dessen zweiter Anschluß über die steuerbare Impedanz (1,3,4) mit dem auf Masse liegenden Fußpunkt des Lautstärkestellers (7) verbunden ist.

2. Einrichtung nach Anspruch 1, **dadurch ge-** **kennzeichnet,** daß als steuerbarer Widerstand (1) eine Zenerdiode verwendet wird, der das Regelsignal ($U_R$) über eine zweite dazu in Reihe liegende Zenerdiode (2) zugeführt wird.

3. Einrichtung nach Anspruch 2, **dadurch gekennzeichnet,** daß Zenerdioden mit einer Durchbruchspannung in der Größenordnung von 3 Volt verwendet werden.

4. Einrichtung nach einem oder mehreren der Ansprüche 1 bis 3, **dadurch gekennzeichnet,** daß der variable Abgriff (9) des Lautstärkestellers (7) über einen ohmschen Widerstand (10) an Masse gelegt ist, dessen Wert kleiner ist als der Nennwert des Lautstärkestellers.

5. Einrichtung nach einem oder mehreren der Ansprüche 1 bis 4, **dadurch gekennzeichnet,** daß zur Erzeugung des Regelsignals ($U_R$) ein Frequenz-Spannungs-Wandler vorgesehen ist, der das Ausgangssignal eines am Fahrzeugtachometer angeordneten Tachogenerators (11) auswertet und aus einem Tiefpaß (12) zur Unterdrückung von HF-Störungen, einem getriggerten Verstärker (13) zur Erzeugung einer symmetrischen Rechteckspannung, einem Differenzierglied (14) und einem Gleichrichter (15) zur Erzeugung einer frequenzabhängigen Gleichspannung sowie einer Subtrahierschaltung (17) zur Bildung einer frequenzabhängigen, von einer Festspannung ($U_F$) aus absinkenden Regelspannung ($U_R$) besteht.

6. Einrichtung nach Anspruch 5, **dadurch gekennzeichnet,** daß der Frequenz-Spannungs-Wandler einen veränderbaren, zwischen dem Gleichrichter (15) und der Subtrahierschaltung (17) liegenden Spannungsteiler (16) zur Einstellung der Regelsteilheit aufweist.

**Claims**

1. Device for increasing the volume of an audio unit used in a motor vehicle, as a function of speed, having an attenuator circuit with a controllable impedance to be arranged in the audio frequency signal path through the audio unit, the signal attenuation of the attenuator circuit being controlled by a control signal, as a function of the vehicle's speed, characterised in that the controllable impedance consists of a controllable resistor (1) and a first RC series element (3, 4) connected in parallel with it, and in that the attenuator circuit furthermore has a mechanically operated volume control (7) and a second RC series element (5, 6) whose first connection is connected to a fixed tap (8) on the volume control (7) and whose second connection is connected via the controllable impedance (1, 3, 4) to the lower end of the volume control (7), which is at earth potential.

2. Device according to Claim 1, characterised in that a Zener diode is used as the controllable resistor (1), to which the control signal ($U_R$) is fed via a second Zener diode (2) connected in series with it.

3. Device according to Claim 2, characterised in that Zener diodes having an avalanche voltage in the order of magnitude of 3 volts are used.

4. Device according to one or more of Claims 1 to 3, characterised in that the variable tap (9) of the volume control (7) is connected to earth via an ohmic resistor (10), whose value is smaller than the nominal value of the volume control.

5. Device according to one or more of Claims 1 to 4, characterised in that a frequency/voltage converter is provided for generating the control signal ($U_R$), which analyses the output signal of a tacho-generator (11) arranged on the vehicle tachometer, and which consists of a low-pass filter (12), to suppress RF interference, a triggered amplifier (13), to generate a symmetrical square-wave voltage, a differentiating element (14) and a rectifier (15) to generate a frequency-dependent DC voltage, and a subtracting circuit (17) for the formation of a frequency-dependent control voltage ($U_R$), which drops down from a fixed voltage ($U_F$).

6. Device according to Claim 5, characterised in that the frequency/voltage converter has a variable voltage divider (16), connected between the rectifier (15) and the subtracting circuit (17), for adjusting the steepness of the control slope.

**Revendications**

1. Dispositif pour augmenter le volume sonore en fonction de la vitesse, destiné à un appareil audio pouvant être installé dans un véhicule automobile, avec un montage d'affaiblissement à disposer dans le parcours de signal à basse fréquence de l'appareil audio, montage qui présente une impédance asservissable et dont l'affaiblissement de signal est commandé par un signal de régulation en fonction de la vitesse de marche, **caractérisé** en ce que l'impédance asservissable est constituée d'une résistance asservissable (1) ainsi que d'un premier circuit série RC (3,4) monté en parallèle à cette résistance, et en ce que le montage d'affaiblissement présente en outre un potentiomètre de volume sonore actionné mécaniquement (7) ainsi qu'un second circuit série RC (5,6), dont la première borne est reliée à une prise fixe (8) du potentiomètre de volume sonore (7) et dont la seconde borne est reliée, par l'intermédiaire de l'impédance asservissable (1,3,4), au point de base mis à la masse du potentiomètre de volume sonore (7).

2. Dispositif selon la revendication 1, caractérisé en ce qu'on utilise comme résistance asservissable (1) une diode Zener, qui reçoit le signal de régulation ($U_R$) par l'intermédiaire d'une seconde diode Zener (2) montée en série avec la première.

3. Dispositif selon la revendication 2, caractérisé en ce qu'on utilise des diodes Zener présentant une tension de rupture de l'ordre de 3 Volts.

4. Dispositif selon une ou plusieurs des revendications 1 à 3, caractérisé en ce que la prise variable (9) du potentiomètre de volume sonore (7) est mise à la masse par l'intermédiaire d'une résistance ohmique (10) dont la valeur est inférieure à la valeur nominale du potentiomètre de volume sonore.

5. Dispositif selon une ou plusieurs des revendications 1 à 4, caractérisé en ce qu'il est prévu pour produire le signal de régulation ($U_R$) un convertisseur fréquence-tension qui évalue le signal de sortie d'une génératrice tachymétrique (11) disposée sur le tachymètre du véhicule, et qui est constitué d'un filtre passe-bas (12) pour supprimer les parasites HF, d'un amplificateur déclenché (13) pour produire une tension rectangulaire symétrique, d'un élément différenciateur (14) et d'un redresseur (15) pour produire une tension continue fonction de la fréquence, ainsi que d'un montage de soustraction (17) pour former une tension de régulation ($U_R$) fonction de la fréquence, diminuant à partir d'une tension fixe ($U_F$).

6. Dispositif selon la revendication 5, caractérisé en ce que le convertisseur fréquence-tension présente un diviseur de tension modifiable (16), situé entre le redresseur (15) et le montage de soustraction (17) et destiné à régler la pente de régulation.

FIG. 1

FIG. 2

FIG.3a

FIG.3b